(19) Europäisches Patentamt
European Patent Office
Office européen des brevets

(11) **EP 1 024 370 B1**

(12) **EUROPEAN PATENT SPECIFICATION**

(45) Date of publication and mention
of the grant of the patent:
**09.04.2008 Bulletin 2008/15**

(51) Int Cl.:
***G01R 31/30*** *(2006.01)*    ***G01R 35/00*** *(2006.01)*
***G01R 19/165*** *(2006.01)*

(21) Application number: **00101269.9**

(22) Date of filing: **26.01.2000**

(54) **Procedure for measuring the threshold voltage of a comparator and an application of this procedure**

Verfahren zur Messung der Schwellenspannung eines Komparators und Anwendung dieses Verfahrens

Procédé de mesure de la tension de seuil d'un comparateur et utilisation de ce procédé

(84) Designated Contracting States:
**DE FR GB**

(30) Priority: **29.01.1999 DE 19903557**

(43) Date of publication of application:
**02.08.2000 Bulletin 2000/31**

(73) Proprietor: **TEXAS INSTRUMENTS
DEUTSCHLAND GMBH
85356 Freising (DE)**

(72) Inventors:
• **Pinta, Heinrich
85356 Freising (DE)**
• **Hernitscheck, Christian
94481 Grafenau-Haus i.W. (DE)**

• **Mayer, Jürgen
85415 Langenbach (DE)**

(74) Representative: **Degwert, Hartmut et al
Prinz & Partner GbR
Rundfunkplatz 2
80335 München (DE)**

(56) References cited:
**US-A- 3 828 255**     **US-A- 4 190 825**
**US-A- 4 574 271**     **US-A- 5 099 209**
**US-A- 5 563 519**

• **PATENT ABSTRACTS OF JAPAN vol. 010, no. 129
(E-403), 14 May 1986 (1986-05-14) & JP 60 259018
A (TOSHIBA KK), 21 December 1985 (1985-12-21)**

**Description**

The invention relates to a procedure for the measurement of the threshold voltage of a comparator, as well as to an application of this procedure.

Microcomputers are often used for the measurement of physical parameters, such as voltage, current, temperature and similar. Normally, the measurements are made in that a capacitor, connected to the input of a microcomputer, is charged up to a voltage level that is related to the parameter to be measured. The microcomputer then initiates a discharge process of this capacitor, and the microcomputer can then compute the parameter to be measured from the time it takes to discharge the capacitor. The input stage of the microcomputer thereby consists of a comparator, the output voltage of which always changes in a characteristic way whenever the voltage applied to its input falls below or - depending on the procedure used - exceeds a specific threshold value. In order to measure the discharge time, the time elapsed is measured as from the beginning of the discharging process of the capacitor, and the end of the discharge time is indicated by a change of the output voltage of the comparator, which shows that the input voltage has fallen below the comparator threshold value. Examples of such measurements, using a type MSP430 microcomputer from Texas Instruments, are described in the handbook "MSP430 Family, Metering Application Report" of 1997, published by Texas Instruments. As an example, on pages 52 to 54 of the said handbook a voltage measuring process using this type of microcomputer is explained in detail.

The above description of the measuring process shows that the threshold voltage of the comparator in the microcomputer constitutes an important parameter as part of the time measurement to be carried out by the microcomputer. The precise knowledge of this threshold voltage is decisive for the precision of the measurements realised. In an attempt to produce microcomputers as cost-effectively as possible, the resources made available for the comparator circuit are very much reduced, which of necessity leads to large variations in the threshold voltage for the individual components in each case. Knowledge of the comparator threshold voltage, essential for the precision of the measurements to be carried out, therefore rests on the ability to determine this threshold voltage with precision.

A method for precise measurement of a voltage is known from US 5,099,209.

It is the object of the invention to indicate a procedure by means of which the threshold voltage of a comparator can be determined with precision, simply and without the use of expensive resources.

The solution to this requirement consists in a procedure for the measurement of the threshold voltage of a comparator, the output voltage of which changing in a characteristic manner, when its input voltage exceeds or falls below its threshold voltage, involving the following steps:

a) Application of a first known voltage U1 to a discharged capacitor connected to the input of the comparator by way of a first resistor, and measurement of the time duration N3 between the commencement of the thereby occurring charging process of the capacitor and the change in the output voltage of the comparator;

b) further complete charging of the capacitor up to the known first voltage U1;

c) discharge of the capacitor by way of a second resistor of the same resistive value as the first resistor, and measurement of the time duration N2 between the commencement of the discharging process and a change of the output voltage of the comparator;

d) application of a second known voltage U2, different from the first voltage U1, to the capacitor by way of the first resistor and renewed measurement of the time duration N1 between the commencement of the now occurring charging process of the capacitor and the change of the output voltage of the comparator; and

e) computation of the threshold voltage $U_{th}$ of the comparator according to the following formula:

$$U_{th} = U1 \cdot \left( 1 - e^{\left( \frac{N3}{N2 - N1} \right) \cdot \ln\left( \frac{U2}{U1} \right)} \right)$$

By the application of this procedure a precise determination of the threshold voltage of a comparator becomes possible with a minimum of circuitry involved. As the procedure shows, only three time measurements have to be carried out, whereupon the computation of the threshold voltage can be carried out.

When applying this procedure to the measurement of a physical parameter, using a microcomputer the measuring input of which is constituted by the input of a comparator to which the capacitor is connected, and which at two outputs supplies the program-controlled voltages U1 and U2, and containing a time measuring device for the measurement of the time duration values N1, N2 and N3, the procedure may be applied before each measuring process, after a pre-determined number of measuring processes or after respective pre-determined time intervals. This mode of application ensures that any changes of the threshold voltage of the comparator due to changes in the ambient temperature, changes of the reference voltage or even ageing processes cannot impair the results of the measurement of the desired physical parameter.

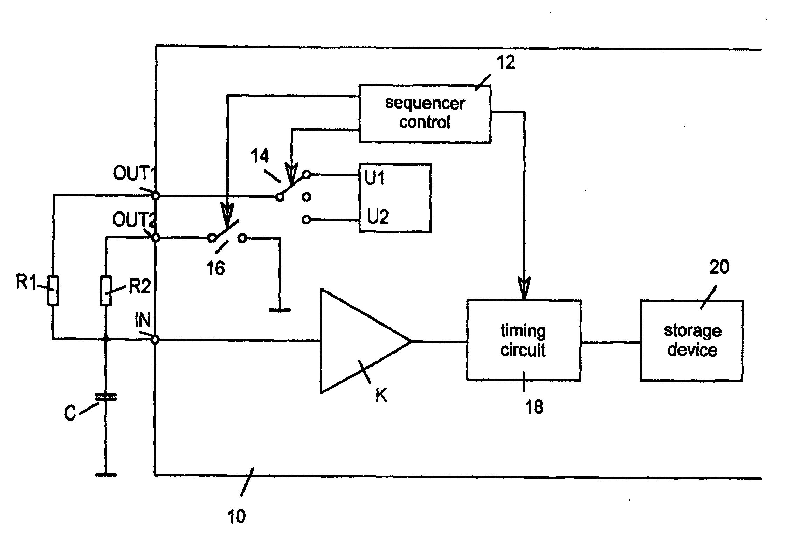

An exemplified application of the invention is now explained with reference to the drawing whose only figure shows, in diagrammatic form, a system for the realisation of the procedure.

In the exemplified application to be described it is assumed that the threshold voltage of a comparator K, representing the input stage of a microcomputer 10, is to be determined. In the drawing, only those components of the microcomputer 10 are schematically represented that are required for the realisation of the procedure to be described. The microcomputer 10 may, for example, be constituted by a type MSP430 microcomputer, as manufactured and marketed by Texas Instruments.

As is apparent, the microcomputer 10 has a digital input IN, which at the same time is the input of the comparator K. Connected to the input IN is a capacitor C, which joins this input to ground. The microcomputer 10 has furthermore two outputs OUT1 and OUT2, whereby a resistor R1 is connected between the output OUT1 and the input IN, and a resistor R2 is connected between the output OUT2 and the input IN. The resistors R1 and R2 are of the same resistance value. The microcomputer 10, under control of the sequencer control 12 and by means of a selector switch 14, can apply either the voltage U1 or U2 to the output OUT1. Also under control of the sequencer control 12 and by means of a switch 16 the output OUT2 can be connected to ground. A timer circuit 18, connected to the output of the comparator K, can be controlled by the sequencer control 12, and a storage device 20 is provided for the storage of the timing values measured by the timer circuit 18, for subsequent processing.

The comparator K has the property that its output voltage changes in a characteristic way when the voltage applied to its input either exceeds or falls below its threshold value $U_{th}$. As an example, its output voltage can change from a low value to a high value when a rising voltage is applied to its input and this then exceeds the threshold value $U_{th}$. On the other hand, its output voltage can change from a high value to a low value as soon as a falling input voltage becomes smaller than the threshold value $U_{th}$. In principle, the comparator has, in fact, a hysteresis, which shows up by the existence of two threshold values, that is one threshold value to respond to an increasing voltage, and a threshold value to respond to a decreasing voltage. For the case here under consideration it shall, however, be assumed that the difference between the threshold values is so small that the hysteresis effect may be neglected.

In the following it shall be explained how the threshold value of the comparator K can be determined by means of the circuit arrangement shown.

The sequencer control 12 takes the selector switch 14 into the position represented in the diagram, where the voltage U1 is applied to the output OUT1. At the same time, the sequencer control 12 activates the timing circuit 18, so that in this timer circuit 18 a counter, as an example, is enabled to run, the reading of which at any moment gives a measure of the time elapsed. As soon as the selector switch 14 is in the position depicted, the initially discharged capacitor C begins to charge up by way of the resistor R1, so that the voltage at the input IN of the comparator K starts to rise. As soon as the - so far unknown - threshold voltage $U_{th}$ is exceeded, the output voltage of the comparator K changes in a characteristic way, for example from a low value to a high value. The consequence of this change in the timer circuit 18 is to stop the counter, used as an example, for measuring the time elapsed. The counter reading reached will be stored as the time duration N3 in the storage device 20, and corresponds to the time elapsed from the commencement of the charging-up process of the capacitor C to a change in the output voltage of the comparator K.

Since the selector switch 14 is still in the position depicted, the capacitor C will eventually be fully charged up to the voltage U1. The sequencer control 12 then takes the selector switch into a neutral middle position whereby the voltage U1 is no longer applied to the output OUT1. At the same time, the sequencer control 12 closes switch 16 and once again starts the timing circuit 18. By closing the switch 16, the capacitor C will be discharged to ground by way of the resistor R2. The consequence of this is that the input voltage of the comparator K decreases. When this voltage falls below its threshold voltage $U_{th}$, its output voltage, in the present exemplified case, changes from a high value to a low value, and this change causes the time measuring process in the timer circuit 18 to be interrupted by stopping the counter contained in it, so that the previously elapsed time duration corresponds exactly to the time duration between the commencement of the discharge process of the capacitor C and the occurrence of the change in the output voltage of the comparator K. The time measurement value thereby obtained will be stored as time duration N2 in the storage device 20.

When the capacitor C is then discharged, the sequencer control 12 takes the selector switch 14 into the position whereby the voltage U2, at difference from the voltage U1, is applied to the output OUT1. At the same time, the timing circuit 18 is once again activated. Now begins a new charging process of the capacitor C by way of the resistor R1, whereby once again the time duration between the commencement of the renewed charging process of the capacitor C until exceeding the threshold voltage $U_{th}$ of the comparator K and the consequential change of its output voltage elapses. The time measurement value thus obtained will be stored as time duration N1 in the storage device 20.

On completion of these procedural steps, all values are known which are required to compute the threshold voltage $U_{th}$ of the comparator K. The following formula is used for this computation:

$$U_{th} = U1 \cdot \left( 1 - e^{\left( \frac{N3}{N2-N1} \right) \cdot \ln\left( \frac{U2}{U1} \right)} \right)$$

This computation can be carried out by a microcomputer suitably programmed.

The procedure described may be advantageously applied in connection with the measurement of physical parameters by using a microcomputer whose input stage is constituted by a comparator, and which, for the purpose of achieving precise measuring results, must be in possession of the precise value of the threshold voltage of the comparator. In connection with the previously mentioned measuring procedure, use of a capacitor C has already been made, since the measurement of the charging and discharging times of this capacitor is always used for the measurement of the different physical parameters. Although, in principle, the resistors R1 and R2 may be added only for the process of determining the threshold voltage of the comparator K, it is also possible, by using a suitable circuit configuration, to use two identical resistors which are already available for the execution of the proper measuring procedures. The procedure for the determination of the threshold voltage of the comparator K can then be carried out in connection with every measurement of a desired parameter, but it is also possible to determine this threshold voltage only after a pre-determined number of measuring processes, or even periodically at the end of specific timing periods.

The determination of the threshold voltage realised is particularly advantageous because the formula given above shows that it is independent from the clock frequency used by the microprocessor for the execution of the time measurements. Furthermore, there is no dependence from the time constants resulting from the RC circuit made up of the resistors R1, R2 and C. Because of the ease of determining the threshold voltage of the comparator, it will not be necessary to use complex circuitry for the inclusion of the comparator in the microcomputer, and this, in no insignificant way, helps towards achieving a cost-effective configuration of the entire microcomputer.

**Claims**

1.  Method for the measurement of the threshold voltage of a comparator, the output voltage of which will be changing in a characteristic manner when its input voltage exceeds or falls below its threshold voltage, involving the following steps:

    a) Application of a first known voltage U1 to a discharged capacitor (C) connected to the input of the comparator (K) by way of a first resistor (R1), and measurement of the time duration N3 between the commencement of the thereby occurring charging process of the capacitor (C) and the change in the output voltage of the comparator;
b) further complete charging of the capacitor (C) up to the known first voltage U1;
c) discharge of the capacitor (C) by way of a second resistor (R2) of the same resistive value as the first resistor (R1), and measurement of the time duration N2 between the commencement of the discharging process and a change of the output voltage of the comparator (K);
d) application of a second known voltage U2, different from the first voltage U1, to the capacitor (C) by way of the first resistor (R1) and renewed measurement of the time duration N1 between the commencement of the now occurring charging process of the capacitor (C) and the change of the output voltage of the comparator (K); and
e) computation of the threshold voltage $U_{th}$ of the comparator (K) according to the following formula:

$$U_{th} = U1 \cdot \left( 1 - e^{\left( \frac{N3}{N2-N1} \right) \cdot \ln\left( \frac{U2}{U1} \right)} \right)$$

2.  Application of the method according to Claim 1 for the measurement of a physical parameter by using a microcomputer (10), the digital measuring input (IN) of which is constituted by the input of a comparator (K), to which is connected the capacitor (C) and which at two outputs makes available the program-controlled voltages U1 and U2, and containing a timing circuit (18) for the measurement of the time duration N1, N2 and N3, wherein the procedure is executed before each measuring process, after a pre-determined number of measuring processes or after certain pre-determined time intervals.

**Patentansprüche**

1.  Verfahren zum Messen der Schwellenspannung eines Komparators, dessen Ausgangsspannung sich in charakteristischer Weise ändert, wenn seine Eingangsspannung seine Schwellenspannung über- oder unterschreitet, mit folgenden Schritten:

    a) Anlegen einer ersten bekannten Spannung U1 an einen mit dem Eingang des Komparators (K) verbundenen entladenen Kondensator (C) über einen ersten Widerstand (R1) und Messen der Zeitdauer N3 zwischen dem Beginn der dadurch eintretenden Aufladung des Kondensators (C) und der Änderung der Ausgangsspannung des Komparators;

b) weiteres vollständiges Aufladen des Kondensators (C) bis auf die bekannte erste Spannung U1;

c) Entladen des Kondensators (C) über einen zweiten Widerstand (R2) mit dem gleichen Widerstandswert wie der erste Widerstand (R1) und Messen der Zeitdauer N2 zwischen dem Beginn der Entladung und der Änderung der Ausgangsspannung des Komparators (K);

d) Anlegen einer zweiten bekannten, von der ersten Spannung U1 verschiedenen Spannung U2 an den Kondensator (C) über den ersten Widerstand (R1) und erneutes Messen der Zeitdauer N1 zwischen dem Beginn der dabei eintretenden Aufladung des Kondensators (C) und der Änderung der Ausgangsspannung des Komparators (K); und

e) Berechnen der Schwellenspannung $U_{th}$ des Komparators (K) nach folgender Formel:

$$U_{th} = U1 \cdot \left( 1 - e^{\left( \frac{N3}{N2 - N1} \right) \cdot \ln\left( \frac{U2}{U1} \right)} \right)$$

2. Anwendung des Verfahrens nach Anspruch 1 zum Messen eines physikalischen Parameters unter Verwendung eines Mikrocomputers (10), dessen digitaler Meßeingang (IN) vom Eingang eines Komparators (K) gebildet ist, an den der Kondensator (C) angeschlossen ist und der an zwei Ausgängen die Spannungen U1 und U2 programmgesteuert abgibt und eine Zeitmeßschaltung (18) zum Messen der Zeitdauern N1, N2 und N3 enthält, wobei das Verfahren vor jedem Meßvorgang, nach einer vorbestimmten Anzahl von Meßvorgängen oder nach bestimmten vorbestimmten Zeitperioden durchgeführt wird.

par ce moyen et la variation de la tension de sortie du comparateur ;

b) le chargement complet du condensateur (C) jusqu'à la première tension connue U1 ;

c) la décharge du condensateur (C) à travers d'une deuxième résistance (R2) de la même valeur résistive que la première résistance (R1), et la mesure de la durée de temps N2 entre le début du processus de décharge et une variation de la tension de sortie du comparateur (K) ;

d) l'application d'une deuxième tension connue U2, différente de la première tension U1, au condensateur (C) à travers de la première résistance (R1) et une nouvelle mesure de la durée de temps N1 entre le début du processus de charge du condensateur (C) se produisant à présent et la variation de la tension de sortie du comparateur (K) ; et

e) le calcul de la tension de seuil $U_{th}$ du comparateur (K) selon la formule suivante :

$$U_{th} = U1 \cdot \left( 1 - e^{\left( \frac{N3}{N2 - N1} \right) \cdot \ln\left( \frac{U2}{U1} \right)} \right)$$

2. Application du procédé selon la revendication 1 pour la mesure d'un paramètre physique en utilisant un microordinateur (10), dont l'entrée de mesure numérique (IN) est constituée de l'entrée d'un comparateur (K), auquel est connecté le condensateur (C) et qui à deux sorties rend utilisables les tensions commandées par programme U1 et U2, et contenant un circuit de cadencement (18) pour la mesure de la durée de temps N1, N2 et N3, dans laquelle la procédure est exécutée avant chaque processus de mesure, après un nombre prédéterminé de processus de mesure ou après certains intervalles de temps prédéterminés.

**Revendications**

1. Procédé pour la mesure de la tension de seuil d'un comparateur, dont la tension de sortie variera d'une manière caractéristique quand sa tension d'entrée dépasse ou passe sous sa tension de seuil, impliquant les étapes suivantes :

a) l'application d'une première tension connue U1 à un condensateur déchargé (C) connecté à l'entrée du comparateur (K) à travers d'une première résistance (R1), et la mesure d'une durée de temps N3 entre le début du processus de charge du condensateur (C) se produisant

**REFERENCES CITED IN THE DESCRIPTION**

**Patent documents cited in the description**

• US 5099209 A

**Non-patent literature cited in the description**

• MSP430 Family, Metering Application Report. Texas Instruments, 1997